# EUROPÄISCHE PATENTANMELDUNG

(11) **EP 2 254 247 A1**
(43) Veröffentlichungstag der Anmeldung: **24.11.2010**
(21) Anmeldenummer: 10160739.8
(22) Anmeldetag: 22.04.2010
(51) Int. Cl.: H03K 17/96

(54) **Sensorschaltung**

(30) Priorität: 18.05.2009 DE 102009021719
(71) Anmelder: Osram Gesellschaft mit Beschränkter Haftung, 81543 München (DE)
(72) Erfinder: Dilger, Richard, 81549 München (DE); Heckmann, Markus, 81379 München (DE)

(57) **Zusammenfassung**

Es wird eine Sensorschaltung angegeben mit einem Verstärker, mit einem kapazitiven Sensor, wobei der kapazitive Sensor in einem Gegenkopplungszweig des Verstärkers angeordnet ist. Weiterhin werden eine Leuchte mit einer derartigen Sensorschaltung sowie ein Verfahren zur Ansteuerung der Leuchte vorgeschlagen.

## Beschreibung

Die Erfindung betrifft eine Sensorschaltung, eine Leuchte mit einer solchen Sensorschaltung und ein Verfahren zum Ansteuern einer Leuchte mit einer solchen Sensorschaltung.

Für eine Vielzahl von Anwendungen kann vorteilhaft ein Taster oder Schalter eingesetzt werden, der ohne bewegliche Mechanik auskommt. Ein Beispiel für einen solchen Schalter ist ein berührungsempfindlicher Schalter bzw. Sensor (auch bezeichnet als "Touchsensor").

Hierbei sei angemerkt, dass nachfolgend der Begriff Schalter sowohl auf eine schaltende Funktion als auch auf die Funktion eines Tasters abstellt. Beispielsweise wird bei der Tastfunktion eine Aktion nur im Wesentlichen für die Dauer der Aktivierung des Tasters ausgeführt, während die Schaltfunktion weitgehend unabhängig von der Dauer der Aktivierung ist. Insbesondere kann ein Taster eine Tastfunktion oder eine Schaltfunktion ausführen, je nach Implementierung.

Es ist bekannt, einen kapazitiven Sensor elektrisch parallel zu einem Kondensator (beispielsweise zu einem bekannten Kondensator oder einem parasitären Halbleiterkondensator) vorzusehen. Durch Berühren des kapazitiven Sensors steigt dessen effektive Kapazität in einem Bereich von z.B. 0,5pF bis 30pF. Somit bedingt die Berührung des kapazitiven Sensors, dass dem Kondensator eine sehr geringe Kapazität parallelgeschaltet wird. Die sich hieraus ergebende Ladungsverschiebungen und Spannungsänderungen sind gering, eine Auswertung derselben erfordert eine aufwändige Elektronik bzw. verhältnismäßig teure Spezial-ICs.

Die **Aufgabe** der Erfindung besteht darin, die vorstehend genannten Nachteile zu vermeiden und insbesondere eine Sensorschaltung anzugeben, die mit hoher Sicherheit und Robustheit eine Betätigung eines kapazitiven Sensors erkennt.

Diese Aufgabe wird gemäß den Merkmalen der unabhängigen Patentansprüche gelöst. Weiterbildungen der Erfindung ergeben sich auch aus den abhängigen Ansprüchen.

Zur Lösung der Aufgabe wird eine Sensorschaltung angegeben
- mit einem Verstärker,
- mit einem kapazitiven Sensor,
- wobei der kapazitive Sensor in einem Gegenkopplungszweig des Verstärkers angeordnet ist.

Der Gegenkopplungszweig verbindet insbesondere einen Ausgang des Verstärkers mit seinem Eingang.

Somit kann eine Betätigung des kapazitiven Sensors mit hoher Sicherheit erkannt werden. Dabei können vorteilhaft günstige Bauteile eingesetzt werden bzw. erfordert eine Auswertung des von dem Verstärker gelieferten Signals dahingehend, ob der kapazitive Sensor berührt wurde oder nicht, keinen großen schaltungstechnischen oder Implementierungs-Aufwand (z.B. durch geeignete Software-Auswertung in einer nachgeschalteten Verarbeitungseinheit).

Als Verstärker können beliebige ein- oder mehrstufige Verstärker eingesetzt werden.

Eine Weiterbildung ist es, dass der Verstärker mindestens eines der folgenden Bauelemente aufweist:
- einen Transistor;
- einen Mosfet;
- einen Operationsverstärker;
- ein Logikgatter, insbesondere in CMOS-Technologie;
- eine Röhre.

Insbesondere können stromsparende Bauteile eingesetzt werden. Auch ist es möglich, dass der Verstärker zumindest zeitweise inaktiv geschaltet wird, um somit elektrische Energie zu sparen.

Eine andere Weiterbildung ist es, dass der Verstärker einen Impedanzwandler aufweist.

Beispielsweise kann der Verstärker eine erste Stufe aufweisen, die als ein Impedanzwandler ausgeführt ist. Hierdurch kann vorteilhaft der Einfluss parasitärer Kapazitäten auf den kapazitiven Sensor reduziert werden.

Insbesondere ist es eine Weiterbildung, dass der Verstärker eine nichtlineare Verstärkerstufe aufweist.

Insbesondere kann eine dem Impedanzwandler nachgeschaltete Stufe als nichtlineare Verstärkerstufe ausgeführt sein. Dies ist von Vorteil, weil durch die Nichtlinearität ein Gleichanteil reduziert werden kann und somit die Erkennung des Zustands des kapazitiven Sensors deutlich verbessert wird.

Auch ist es eine Weiterbildung, dass der Verstärker eine zweitstufige Transistorschaltung aufweist.

Insbesondere können eine Abfolge von npn-Transistoren und/oder pnp-Transistoren vorgesehen sein, wobei der erste Transistor als Impedanzwandler und der zweite Transistor als Verstärker, insbesondere als nichtlinearer Verstärker, eingesetzt wird.

Ferner ist es eine Weiterbildung, dass ein Ausgangssignal des Verstärkers einer Verarbeitungseinheit, insbesondere einem Mikrokontroller, zuführbar ist.

Beispielsweise könnte das Ausgangssignal in der Verarbeitungseinheit entsprechend ausgewertet werden. Je deutlicher die Zustände des kapazitiven Sensors (berührt bzw. nicht berührt) unterscheidbar sind, desto robuster ist die Auswertung.

Anstelle des Mikrokontrollers können sonstige digitale und/oder analoge Schaltungen als Verarbeitungseinheit bzw. zur Auswertung des Ausgangssignals des Verstärkers eingesetzt werden.

Im Rahmen einer zusätzlichen Weiterbildung ist das Ausgangssignal des Verstärkers über ein Tiefpassfilter der Verarbeitungseinheit zuführbar.

Das Tiefpassfilter ermöglicht eine verbesserte Detektion des Zustands des kapazitiven Sensors.

Eine nächste Weiterbildung besteht darin, dass die Verarbeitungseinheit abhängig von dem Ausgangssignal des Verstärkers eine vorgegeben Aktion durchführt.

Somit kann in Abhängigkeit von dem Zustand des kapazitiven Sensors bzw. in Abhängigkeit von einer bestimmten Abfolge von Zuständen eine vorgegebene Aktion durchgeführt werden.

Beispielsweise können bestimmte Abfolgen von kurzer/langer Berührung des kapazitiven Sensors detektiert werden. Jede solche Abfolge kann mit einer unterschiedlichen vorgegebenen Aktion verknüpft sein und deren Aktivierung initiieren.

Eine Ausgestaltung ist es, dass die vorgegebene Aktion mindestens eine der folgenden Aktionen umfasst:
- Einschalten eines Aktors;
- Ausschalten eines Aktors;
- Geregeltes Ansteuern eines Aktors mit einem Sollwert, wobei der Sollwert anhand des Ausgangssignals bestimmbar ist.

Hierbei kann der Aktor eine beliebige z.B. elektrisch aktivierbare Komponente sein. Beispielsweise kann der Aktor ein Leuchtmittel, z.B. mindestens ein Halbleiterleuchtelement, einer Leuchte sein. Insbesondere ist es möglich, dass für die Dauer einer Betätigung des kapazitiven Sensors ein Aktor auf einen vorgegebenen Sollwert geregelt, z.B. gedimmt wird. Mit anderen Worten kann durch Betätigen des kapazitiven Sensors für die Dauer der Betätigung das Leuchtmittel entsprechend gedimmt werden (jeweils heller oder dunkler).

Eine alternative Ausführungsform besteht darin, dass der Verstärker mittels einer Wechselspannung angesteuert wird.

Insbesondere kann die Wechselspannung ein Taktsignal, z.B. ein Taktsignal der Verarbeitungseinheit, sein. Somit kann das Taktsignal beispielsweise von einem Mikrokontroller bereitgestellt werden.

Eine nächste Ausgestaltung ist es, dass die Schaltung mit einer Gleichspannung versorgt wird, wobei die Gleichspannung insbesondere von mindestens einer Batterie bereitgestellt wird.

Beispielsweise kann es sich bei der Batterie um eine wiederaufladbare Batterie oder um eine sonstige wiederaufladbare elektrische Energiequelle handeln.

Die vorstehend genannte Aufgabe wird auch gelöst durch eine Leuchte mit einer Sensorschaltung wie hierin beschrieben, wobei die Leuchte mittels des kapazitiven Sensors schaltbar und/oder dimmbar ausgeführt ist

Weiterhin wird die oben genannte Aufgabe gelöst mittels eines Verfahrens zur Ansteuerung einer Leuchte, wobei abhängig von einem Ausgangssignal der Sensorschaltung wie hierein beschrieben, die Leuchte eingestellt wird.

Dabei umfasst das Einstellen der Leuchte z.B. ein Einschaltung, ein Ausschalten sowie ein Dimmen der Leuchte.

Ausführungsbeispiele der Erfindung werden nachfolgend anhand der Zeichnungen dargestellt und erläutert.

Es zeigen:
- Fig.1: eine beispielhafte Schaltungsanordnung für eine kapazitätsgewichtete Sensorschaltung;
- Fig.2: eine alternative Schaltungsanordnung für eine kapazitätsgewichtete Sensorschaltung;
- Fig.3: ein zusätzliches Schaltungsbeispiel für eine kapazitätsgewichtete Sensorschaltung;
- Fig.4: ein Ausgangssignal einer kapazitätsgewichteten Sensorschaltung bei nichtbetätigtem kapazitiven Sensor;
- Fig.5: ein Ausgangssignal einer kapazitätsgewichteten Sensorschaltung bei betätigtem kapazitiven Sensor;
- Fig.6: ein Diagramm zur Visualisierung eines Übergang des Ausgangssignals bei Berührung des kapazitiven Sensors.

Bei direkter Parallelschaltung eines kapazitiven Sensors zu anderen bekannten Kapazitäten bewirkt ein Berühren des kapazitiven Sensors lediglich eine geringfügige Ladungsverschiebung, die entsprechend aufwändig ausgewertet werden muss.

Der hier vorgeschlagene Ansatz nutzt einen Verstärker und bindet den kapazitiven Sensor in eine Gegenkopplung des Verstärkers ein. Der Einfluss des kapazitiven Sensors auf das auszuwertende Signal wird entsprechend der Verstärkung des Verstärkers deutlich erhöht. Somit ist eine Zustandsveränderung des kapazitiven Sensors deutlich detektierbar bzw. können zur Detektion einer solchen Zustandsveränderung preiswerte Bauelemente eingesetzt werden. Die Detektion bzw. Auswertung des Signals kann mittels eines Mikrokontrollers, allgemeiner integrierter Schaltungen und/oder diskreter Elektronik erfolgen.

Durch die Verstärkung wird die Kapazitätsänderung des Sensors entsprechend der Verstärkung höher gewichtet als bei der bloßen Parallelschaltung des kapazitiven Sensors mit einem Kondensator, so dass die Rückwirkung des kapazitiven Sensors auf den bekannten Kondensator groß wird und zudem über die Verstärkung parametrierbar ist.

Der Verstärker kann mindestens eine der folgenden Komponenten umfassen:
- einen Operationsverstärker;
- einen Transistor;
- einen Mosfet.

Beispielsweise können günstige Schaltungen aus mehreren Transistoren (z.B. umfassend zwei Transistoren) eingesetzt werden, um das Signal des kapazitiven Sensors zu detektieren.

Der kapazitive Sensor kann z.B. realisiert sein, indem ein elektrischer Kontakt der Schaltung an einem Gehäuse nach außen geführt wird und eine Kupfer-Fläche z.B. hinter einem FR-1-Platinen-Material von 1,6mm Dicke angeordnet ist. Die Kupfer-Fläche in dem Gehäuse wird nicht berührt, jedoch ergibt sich eine Kapazitätsänderung durch Berührung des elektrischen Kontakt. Alternativ kann die Kupfer-Fläche auch an der Gehäuse-Innenwand angeordnet sein.

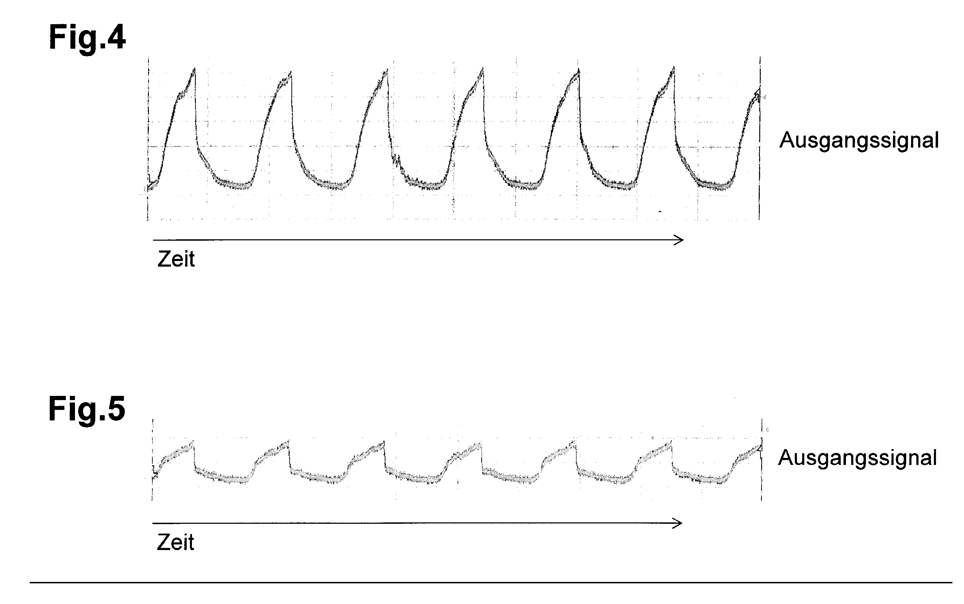

**Fig.4** zeigt ein Ausgangssignal einer kapazitätsgewichteten Sensorschaltung bei nichtbetätigtem kapazitiven Sensor und

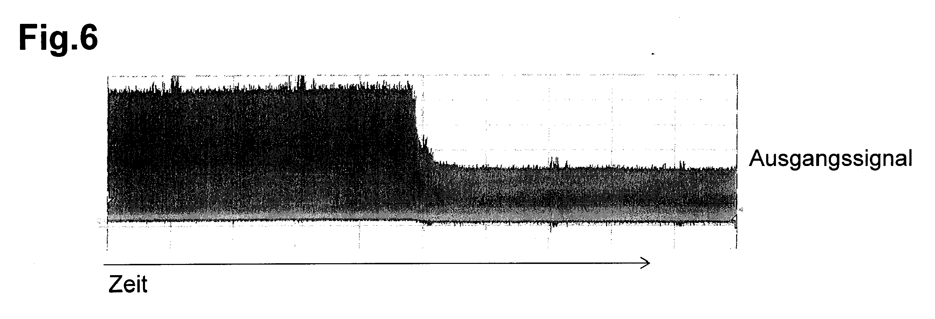

**Fig.5** zeigt ein Ausgangssignal der Schaltung bei Berührung des kapazitiven Sensors. **Fig.6** zeigt den Übergang des Ausgangssignals bei Berührung des kapazitiven Sensors. Der Unterschied der beiden Signal bei Berührung und ohne Berührung des Sensors ist aufgrund des hier vorgestellten Ansatzes stark ausgeprägt und kann daher mit geringem elektrischem Aufwand mit hoher Sicherheit detektiert werden.

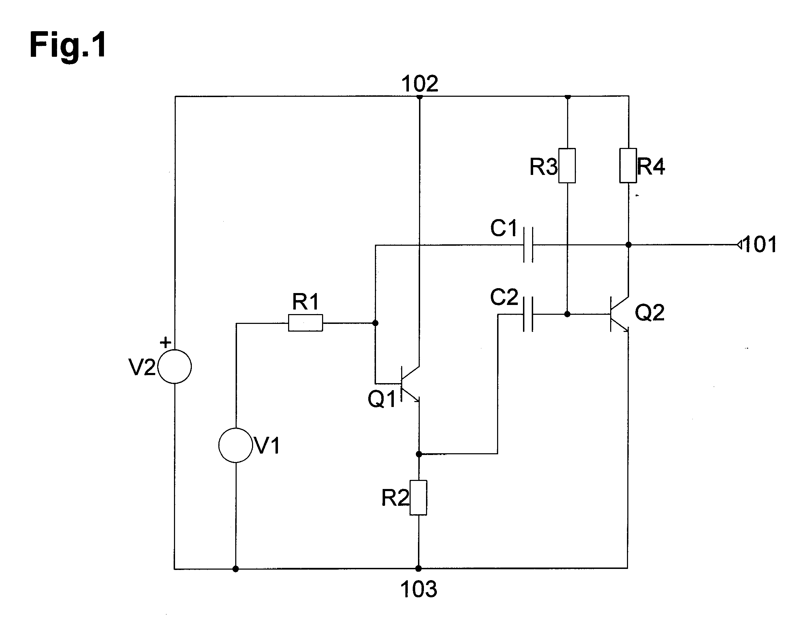

**Fig.1** zeigt eine beispielhafte Schaltungsanordnung für eine kapazitätsgewichtete Sensorschaltung.

Eine Spannungsquelle V2 ist mit ihrem positiven Anschluss mit einem Knoten 102 und mit ihrem negativen Anschluss mit einem Knoten 103 verbunden. Eine Wechselspannungsquelle V1 ist mit ihrem ersten Pol mit dem Knoten 103 und mit ihrem zweiten Pol über einen Widerstand R1 mit der Basis eines npn-Transistors Q1 verbunden. Die Basis des Transistors Q1 ist weiterhin über einen Kondensator C1 mit einem Anschluss 101 verbunden. Der Kollektor des Transistors Q1 ist mit dem Knoten 102 und der Emitter des Transistors Q1 ist über einen Widerstand R2 mit dem Knoten 103 verbunden. Der Emitter des Transistors Q1 ist weiterhin über einen Kondensator C2 mit der Basis eines npn-Transistors Q2 verbunden. Zwischen der Basis des Transistors Q2 und dem Knoten 102 ist ein Widerstand R3 angeordnet. Der Emitter des Transistors Q2 ist mit dem Knoten 103 verbunden und der Kollektor des Transistors Q2 ist einerseits mit dem Anschluss 101 und andererseits über einen Widerstand R4 mit dem Knoten 102 verbunden.

Bei dem Kondensator C1 handelt es sich um einen kapazitiven Berührungssensor (bzw. bildet dieser Kondensator C1 die Kapazität des Berührungssensors nach). Der Kondensator C1 ist im Gegenkopplungszweig des Verstärkers umfassend die Transistoren Q1 und Q2 angeordnet. Entsprechend der Parametrierung des Verstärkers aus Q1 und Q2 kann die Zustandsveränderung des Sensors ("berührt" bzw. "nicht berührt") mit einer hohen Erkennungsrate robust detektiert werden. Der Aufbau des Verstärkers mit zwei handelsüblichen Transistoren Q1 und Q2 ist äußerst kostengünstig.

Der Transistor Q1 arbeitet als Impedanzwandler, der Transistor Q2 wird als ein nichtlinearer Verstärker betrieben, dessen Ausgangsignal eine Ruhelage nahe 0V haben kann. Die Wechselspannungsquelle V1 kann ein Taktsignal bereitstellen, das z.B. von einem Mikrokontroller (nicht dargestellt) zur Verfügung gestellt wird. Die Spannungsquelle V2 kann als eine Batterie ausgeführt sein.

Der Wert des Kondensators C1 (Berührungssensor) ist ohne Berührung sehr klein, bei Berührung liegt der Wert des Kondensators C1 im pF-Bereich (im Beispiel von Fig.1: 1pF). Optional kann auch ein Widerstand in Reihe zu dem Kondensator C1 vorgesehen sein.

Der Anschluss 101 liefert ein Ausgangssignal für den Mikrokontroller (nicht dargestellt), der durch geeignete Auswertung erkennt, ob der Berührungssensor berührt wird oder nicht. Entsprechend kann der Mikrokontroller eine vorgegebene Aktion durchführen, z.B. eine Leuchte ansteuern (einschalten, ausschalten, dimmen).

Ein Anwendungsbeispiel für die vorstehend gezeigte Schaltungsanordnung ist die Verwendung in einer Leuchte, z.B. einer portablen Leuchte (Taschenlampe). Über den kapazitiven Sensor (symbolisch dargestellt durch den Kondensator C1 in Fig.1) wird die Leuchte eingeschaltet oder ausgeschaltet. Auch ist es möglich, dass z.B. durch ein vorgegebenes Berührschema die Leuchte gedimmt wird. Beispielsweise kann eine kurze Berührung oder eine lange Berührung detektiert werden. Auch könnte ein wiederholtes Klopfen als ein besonderes Signal (z.B. zum sofortigen Ausschalten der Leuchte) erkannt werden. Ein dauerhaftes Berühren des kapazitiven Sensors könnte ein stufenloses (oder stufenweises) Dimmen der Leuchte starten, wobei ein Ende dieser Berührung den Dimmzustand einfriert und die Leuchte mit dieser eingestellten Helligkeit weiterleuchtet.

Die in Fig.1 gezeigten Bauteile könnten insbesondere wie folgt dimensioniert bzw. gewählt sein:

| | |
|---|---|
| Q1 | BC847C |
| Q2 | BC847C |
| C1 | 0,1p (bei Berührung 1pF) |
| C2 | 1n |
| R1 | 2,2M |
| R2 | 22k |
| R3 | 1M |
| R4 | 15k |

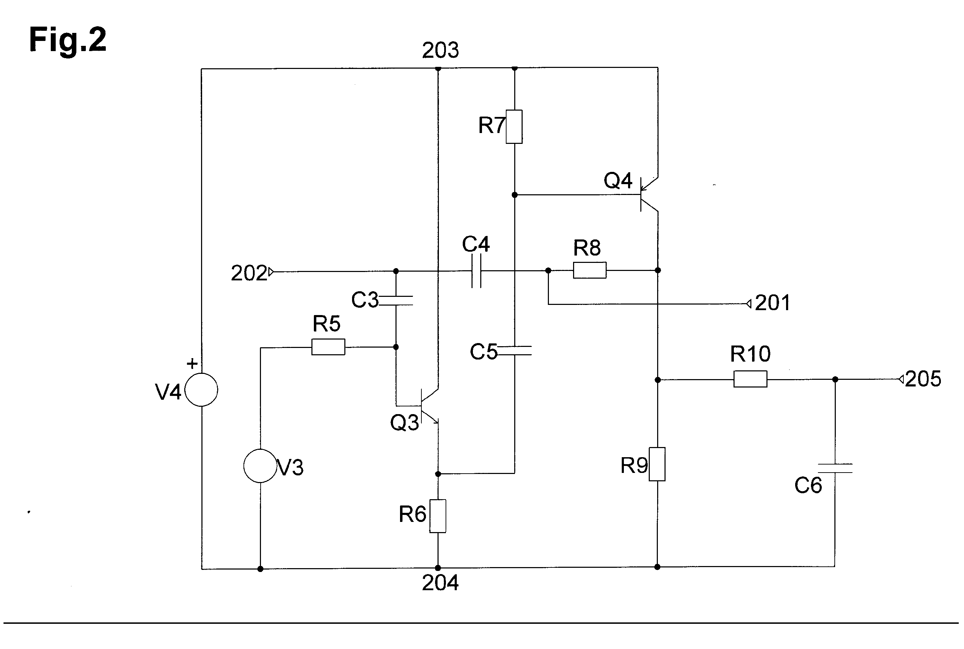

**Fig.2** zeigt eine alternative Schaltungsanordnung für eine kapazitätsgewichtete Sensorschaltung.

Eine Gleichspannungsquelle V4 (z.B. eine Batterie) ist mit ihrem positiven Pol mit einem Knoten 203 und mit ihrem negativen Pol mit einem Knoten 204 verbunden. Eine Wechselspannungsquelle V3 ist einerseits mit dem Knoten 204 und andererseits über einen Widerstand R5 mit der Basis eines npn-Transistors Q3 verbunden. Die Basis des Transistors Q3 ist über einen Kondensator C3 mit einem Anschluss 202 verbunden, der Anschluss 202 ist über einen Kondensator C4 mit einem Anschluss 201 verbunden, wobei der Anschluss 201 über einen Widerstand R8 mit dem Kollektor eines pnp-Transistors Q4 verbunden ist. Der Emitter des Transistors Q3 ist über einen Widerstand R6 mit dem Knoten 204 verbunden. Der Emitter des Transistors Q3 ist weiterhin über einen Kondensator C5 mit der Basis des Transistors Q4 verbunden. Die Basis des Transistors Q4 ist auch über einen Widerstand R7 mit dem Knoten 203 verbunden, der ferner mit dem Emitter des Transistors Q4 verbunden ist. Der Kollektor des Transistors Q4 ist zusätzlich über einen Widerstand R9 mit dem Knoten 204 verbunden. Schließlich ist der Kollektor des Transistors Q4 über einen Widerstand R10 mit einem Anschluss 205 verbunden, wobei zwischen dem Anschluss 205 und dem Knoten 204 ein Kondensator C6 angeordnet ist.

Die Kombination aus den Transistoren Q3 und Q4 stellt eine nichtlinear Verstärkerstufe mit Impedanzwandler dar. Die Kondensatoren C3 und C5 dienen einer Brumm-Minimierung. Der Kondensator C3 kann ggf. auch entfallen bzw. durch eine direkte Verbindung ersetzt werden. Der Kondensator C4 entspricht dem kapazitiven Sensor, der einerseits mit einer Kupfer-Fläche (Anschluss 202) innerhalb des Gehäuses und andererseits mit einem aus dem Gehäuse herausgeführten Kontakt (Anschluss 201) verbunden ist. An dem Anschluss 205 liegt das auswertbare Signal an, das optional mittels des RC-Filters aus Widerstand R10 und Kondensator C6 weitgehend auf den Gleichanteil des Ausgangssignals beschränkt wird.

Das über den Anschluss 205 bereitgestellte Signal kann unmittelbar von einem Mikrokontroller (nicht dargestellt) ausgewertet werden. Selbstverständlich kann anstelle des Mikrokontrollers auch eine andere digitale oder analoge Auswerteschaltung vorgesehen sein.

Die in Fig.2 gezeigten Bauteile könnten insbesondere wie folgt dimensioniert bzw. gewählt sein:

| | |
|---|---|
| Q3 | BC847C |
| Q4 | BC857C |
| C3 | 47p |
| C4 | 1p |
| C5 | 2n |
| C6 | 10n |
| R5 | 1,2M |
| R6 | 2,2k |
| R7 | 100k |
| R8 | 3,3k |
| R9 | 22k |
| R10 | 22k |

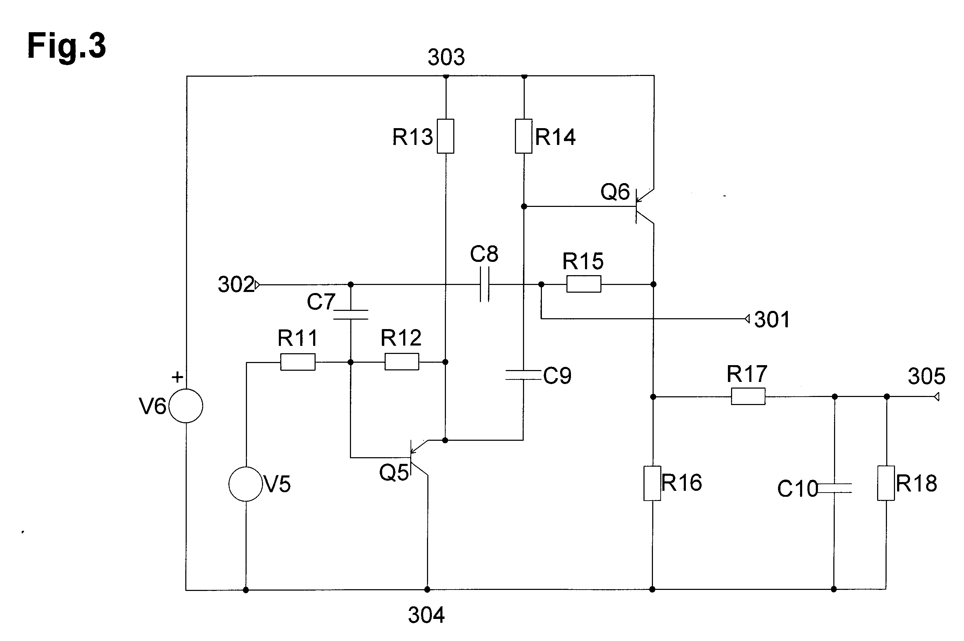

**Fig.3** zeigt ein zusätzliches Schaltungsbeispiel für eine kapazitätsgewichtete Sensorschaltung.

Eine Gleichspannungsquelle V6 ist mit ihrem positiven Pol mit einem Knoten 303 und mit ihrem negativen Pol mit einem Knoten 304 verbunden. Die Gleichspannungsquelle V6 kann beispielsweise eine (wiederaufladbare) Batterie umfassen. Eine Wechselspannungsquelle V5 ist einerseits mit dem Knoten 304 und andererseits über einen Widerstand R11 mit der Basis eines pnp-Transistors Q5 verbunden. Die Basis des Transistors Q5 ist weiterhin über einen Kondensator C7 mit einem Anschluss 302 verbunden. Zusätzlich ist die Basis des Transistors Q5 über einen Widerstand R12 mit dem Emitter des Transistors Q5 verbunden. Der Kollektor des Transistors Q5 ist mit dem Knoten 304 verbunden. Der Emitter des Transistors Q5 ist ferner über einen Widerstand R13 mit dem Knoten 303 verbunden. Auch ist der Emitter des Transistors Q5 über einen Kondensator C9 mit der Basis eines pnp-Transistors Q6 verbunden. Die Basis des Transistors Q6 ist über einen Widerstand R14 mit dem Knoten 303 verbunden, der wiederum mit dem Emitter des Transistors Q6 verbunden ist. Der Anschluss 302 ist über einen Kondensator C8 mit einem Anschluss 301 verbunden, wobei der Anschluss 301 über einen Widerstand R15 mit dem Kollektor des Transistors Q6 verbunden ist. Der Kollektor des Transistors Q6 ist ferner über einen Widerstand R16 mit dem Knoten 304 verbunden. Auch ist der Kollektor des Transistors Q6 über einen Widerstand R17 mit einem Anschluss 305 verbunden. Zwischen dem Anschluss 305 und dem Knoten 304 ist eine Parallelschaltung aus einem Kondensator C10 und einem Widerstand R18 angeordnet.

Die Anordnung gemäß Fig.3 ist ähnlich zu dem Schaltungsbeispiel aus Fig.2. Der Impedanzwandler Q5 ist im Gegensatz zu dem Impedanzwandler Q3 als ein pnp-Transistor ausgeführt. Weiterhin ist parallel zu dem Kondensator C10 noch ein Widerstand R18 vorhanden zur Einstellung des Pegels des an dem Anschluss 305 bereitgestellten Signals.

Die Anschlüsse 301, 302 und 305 entsprechen funktional den Anschlüssen 201, 202 und 205 gemäß Fig.2.

Die in Fig.3 gezeigten Bauteile könnten insbesondere wie folgt dimensioniert bzw. gewählt sein:

| | |
|---|---|
| Q5 | BC857C |
| Q6 | BC857C |
| C7 | 47p |
| C8 | 1p |
| C9 | 2,2n |
| C10 | 10n |
| R11 | 1,2M |
| R12 | 1M |
| R13 | 33k |
| R14 | 100k |
| R15 | 3,3k |
| R16 | 15k |
| R17 | 47k |
| R18 | 220k |

## Patentansprüche

1. Sensorschaltung,
- mit einem Verstärker (Q1, Q2),
- mit einem kapazitiven Sensor (C1),
- wobei der kapazitive Sensor (C1) in einem Gegenkopplungszweig des Verstärkers (Q1, Q2) angeordnet ist.

2. Sensorschaltung nach Anspruch 1, bei der der Verstärker mindestens eines der folgenden Bauelemente aufweist:
- einen Transistor;
- einen Mosfet;
- einen Operationsverstärker;
- ein Logikgatter, insbesondere in CMOS-Technologie;
- eine Röhre.

3. Sensorschaltung nach einem der vorhergehenden Ansprüche, bei der der Verstärker einen Impedanzwandler (Q1) aufweist.

4. Sensorschaltung nach einem der vorhergehenden Ansprüche, bei der der Verstärker eine nichtlineare Verstärkerstufe (Q2) aufweist.

5. Sensorschaltung nach einem der vorhergehenden Ansprüche, bei der der Verstärker eine zweitstufige Transistorschaltung (Q1, Q2; Q3, Q4; Q5, Q6) aufweist.

6. Sensorschaltung nach einem der vorhergehenden Ansprüche, bei der ein Ausgangssignal des Verstärkers einer Verarbeitungseinheit, insbesondere einem Mikrokontroller, zuführbar ist.

7. Sensorschaltung nach Anspruch 6, bei der das Ausgangssignal des Verstärkers (Q3, Q4) über ein Tiefpassfilter (R10, C6) der Verarbeitungseinheit zuführbar ist.

8. Sensorschaltung nach einem der Ansprüche 6 oder 7, bei der die Verarbeitungseinheit abhängig von dem Ausgangssignal des Verstärkers eine vorgegeben Aktion durchführt.

9. Sensorschaltung nach Anspruch 8, bei der die vorgegebene Aktion mindestens eine der folgenden Aktionen umfasst:
- Einschalten eines Aktors;
- Ausschalten eines Aktors;
- Geregeltes Ansteuern eines Aktors mit einem Sollwert, wobei der Sollwert anhand des Ausgangssignals bestimmbar ist.

10. Sensorschaltung nach einem der vorhergehenden Ansprüche, bei der der Verstärker mittels einer Wechselspannung (V1) angesteuert wird.

11. Sensorschaltung nach Anspruch 10, bei der die Wechselspannung ein Taktsignal ist.

12. Sensorschaltung nach einem der vorhergehenden Ansprüche, bei der die Schaltung mit einer Gleichspannung (V2) versorgt wird, wobei die Gleichspannung insbesondere von mindestens einer Batterie bereitgestellt wird.

13. Sensorschaltung nach Anspruch 12, bei der die Batterie (V2) eine wiederaufladbare Batterie ist.

14. Leuchte mit einer Sensorschaltung gemäß einem der vorhergehenden Ansprüche, wobei die Leuchte mittels des kapazitiven Sensors schaltbar und/oder dimmbar ausgeführt ist.

15. Verfahren zur Ansteuerung einer Leuchte, wobei abhängig von einem Ausgangssignal der Sensorschaltung gemäß einem der Ansprüche 1 bis 13 die Leuchte eingestellt wird.
